# EUROPEAN PATENT APPLICATION

(11) **EP 1 970 977 A2**
(43) Date of publication of application: **17.09.2008**
(21) Application number: 08152641.0
(22) Date of filing: 12.03.2008
(51) Int. Cl.: H01L 51/52

(54) **White organic light emitting device including color control layer**

(30) Priority: 13.03.2007 KR 20070024672
(71) Applicant: Samsung Electronics Co., Ltd., Suwon-si, Gyeonggi-do 442-742 (KR)
(72) Inventor: Noh, Tae-yong, Samsung Advanced Institute of Technology, Yongin-si, Gyeonggi-do (KR); Hwang, Euk-che, Samsung Advanced Institute of Technology, Yongin-si, Gyeonggi-do (KR); Tamura, Shinchiro, Samsung Advanced Institute of Technology, Yongin-si, Gyeonggi-do (KR); Kido, Junji, Samsung Advanced Institute of Technology, Yongin-si, Gyeonggi-do (KR)
(74) Representative: Zijlstra, Robert Wiebo Johan

(57) **Abstract**

Provided herein is a white organic light-emitting device comprising a color control layer. The white organic light-emitting device comprises at least one white organic light emitting unit interposed between an anode and a cathode, and a color control layer interposed between the cathode and the at least one white organic light emitting unit, the color control layer having an electron transport capability and a light interference effect.

## Description

The present disclosure relates to an organic light emitting device, and more particularly, to a white OLED (organic light emitting device), which comprises a color control layer producing a light interference effect, and which emits light that is (nearly) pure white light. The organic light emitting device described herein has excellent efficiency.

In general, organic light emitting devices (OLEDs) are structured such that holes supplied from an anode, recombine with electrons supplied from a cathode, in an organic light emitting layer interposed between the anode and the cathode, and as a result light is emitted. OLEDs have excellent color reproduction properties, quick response speeds, self-emissive properties, small thicknesses, high contrast ratios, wide viewing angles, and low power consumption properties, and thus are regarded to be next wave in optical-generation devices. OLEDs have a wide range of applications including televisions, PC monitors, mobile communication terminals, MP3 players, and car navigation systems. OLEDs are self-emissive and therefore can be used as interior or exterior illuminating devices and as signboards. In addition, OLEDs are environmentally friendly because they create lower levels of carbon dioxide emissions than conventional illuminating devices.

Prior art white organic light emitting devices are able to control the color emitted, by varying the thickness of the hole injection layer on the anode side. However, when a white organic light emitting device comprises a tandem structure in order to increase the efficiency of the device, the plurality of hole injection layers used increases the thickness, and thus, the white organic light emitting devices are also too thick.

According to U.S. Patent Application No. 2002/0197511, color variation can be obtained by varying the thickness of an emission layer by using a phosphor emissive material. Such a method, however, can be applied only to an emissive layer formed of a phosphor emissive material. According to U.S. Patent Application No. 2003/0189401, color variation can be obtained by varying the thickness of a hole injection layer formed of N,N'-di(1-naphthyl)-N,N'-diphenylbenzidine (α-NPD). Such a method, however, is disadvantageous in that emissive wavelengths corresponding to wavelengths in the short range are changed.

In 2006, Princeton University fabricated a white OLED having a tandem structure, using a phosphor emissive material, by adjusting the thickness of the hole injection layer formed of α-NPD so as to induce color variation. Such a method, however, has the disadvantages described previously as the thickness of the hole injection layer was changed (Advanced Materials, 2006, Vol.18, p339.)

As described herein, provides a white organic light emitting device including a color control layer interposed between an emissive layer and a cathode of the white organic light emitting device, i.e. an organic device emitting (near-)white light, the color control layer having an electron transport capability and a light interference effect. The color control layer controls green, blue, and red light in order to improve the color balance of the white organic light emitting device.

The white organic light emitting device can be applied without any consideration of the material used as an emissive layer, and in the case of a white organic light emitting device having a tandem structure, the color balance can be improved by controlling the thickness of only one color control layer.

In one embodiment, there is provided a white organic light emitting device comprising at least one white organic light emitting unit, interposed between an anode and a cathode, and a color control layer interposed between the cathode and the at least one white organic light emitting unit, the color control layer having an electron transport capability and a light interference effect.

In another embodiment, the color control layer comprises an arylamine-based organic compound, a metal, a metal oxide, a metal carbide, a metal halide, or a combination comprising at least one of the foregoing color control layer materials. The arylamine-based organic compound is selected from 2,9-dimethyl-4,7-diphenyl-1,10-phenanthroline (BCP), bis(2-methyl-8-quinolinolato)(*para*-phenylphenolato)aluminium(III) (Balq), 4,4'-bis(carbazol-9-yl)biphenyl (CBP), 4,7-diphenyl-1,10-phenanthroline (Bphen), 3-(biphenyl-4-yl)-4-phenyl-5-(4-tert-butylphenyl)-1,2,4-triazole (TAZ), or a combination comprising at least one of the foregoing arylamine-based compounds. The metal oxide is selected from oxides of Ba, Li, Mg, W, Mo, V, Ti, Cs, or a combination comprising at least one of the foregoing metal oxides. The metal oxide, metal carbide, or metal halide is selected from MoO₃, V₂O₅, WO₃, TiO₂, Cs₂CO₃, BaF, LiF, CsF, or a combination comprising at least one of the foregoing metal oxides, carbides, and halides.

In one embodiment, the white organic light emitting unit comprises: a hole transport layer disposed close to the anode; a white emissive layer emitting white light disposed close to the hole transport layer; an electron transport layer disposed close to the white emissive layer; and an electron injection layer disposed close to the electron transport layer, wherein the color control layer has a higher electron mobility rate than the electron transport layer.

In another embodiment, the color control layer has an electron mobility rate of 10⁻⁶cm²/Vs or more.

In one embodiment, the white emissive layer comprises one green emissive layer, one blue emissive layer, and one red emissive layer, and a charge generation layer is interposed between the green emissive layer and the blue emissive layer, or between the blue emissive layer and the red emissive layer.

In another embodiment, the charge generation layer comprises an arylamine-based organic compound, a metal, a metal oxide, a metal carbide, a metal halide, or a combination comprising at least one of the foregoing charge generation layer materials. The arylamine-based organic compound is selected from N,N'-dinaphthyl-N,N'-diphenyl bendizine (α-NPD), tris(2-naphthylphenylamino)triphenyl-amine (2-TNATA), 4,4',4"-tris(N,N-diphenyl-amino)triphenylamine (TDATA), 4,4',4"-tris[N,N-(m-tolyl)phenylamino]triphenylamine (MTDATA), 2,2',7,7'-Tetrakis(diphenylamin)-9,9'-spirobifluorene (spiro-TAD), N,N'-di(1-naphthyl)-N,N'-diphenyl-4,4'-diamonobiphenyl (spiro-NPB), or a combination comprising at least one of the foregoing arylamine-based compounds. The metal is selected from Cs, Mo, V, Ti, W, Ba, Li, or a combination comprising at least one of the foregoing metals. The metal oxide, metal carbide, or metal halide is selected from Re₂O₇, MoO₃, V₂O₅, WO₃, TiO₂, Cs₂CO₃, BaF, LiF, CsF, or a combination comprising at least one of the foregoing metal oxides, carbides or borides.

In yet another embodiment, each of the green, blue and red emissive layers comprises a host material and a fluorescent or phosphorescent light-emitting material as a dopant.

The above and other features and advantages of the present invention will become more apparent by describing in detail exemplary embodiments thereof with reference to the attached drawings in which:
FIG. 1 is a sectional view of an exemplary white organic light emitting device comprising a color control layer;
FIG. 2 is a graphical view illustrating the emissive spectrum of the white organic light emitting device illustrated in FIG. 1 with respect to the thickness of the color control layer;
FIG. 3 is a sectional view of another exemplary white organic light emitting device comprising a color control layer; and
FIG. 4 is a view illustrating the color coordinate system for each of the white organic light emitting devices illustrated in FIGS. 2 and 3, showing the color variation with respect to the thickness of the color control layer.

The present invention will now be described more fully with reference to the accompanying drawings, in which exemplary embodiments of the invention are shown. Like reference numerals in the drawings denote like elements, and thus repetitive description will be omitted.

It will be understood that when an element or layer is referred to as being "on," "interposed," "disposed," or "between" another element or layer, it can be directly on, interposed, disposed, or between the other element or layer or intervening elements or layers can be present.

As used herein, the expression "disposed close to" refers to one layer in contact with another layer through a common surface, or alternatively, that another layer or layers can be interposed between the adjacent layers. For example, a hole injection layer can be interposed between the anode and a hole transport layer.

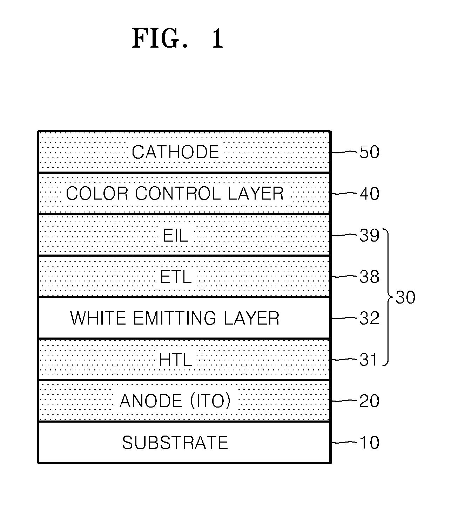

In one embodiment, a white organic light emitting device comprising a color control layer is provided, as illustrated in FIG. 1. Referring to FIG. 1, an anode 20 is disposed on a substrate 10, a white organic light emitting unit 30 is disposed on the anode 20, a color control layer 40, is disposed on the white organic light emitting unit 30, and a cathode 50 is disposed on the color control layer 40.

The color control layer 40 is formed of a material comprising an arylamine-based organic compound, a metal, a metal oxide, a metal carbide, a metal halide, or a combination comprising at least one of the foregoing color control layer materials. Examples of the arylamine-based organic compound include2,9-dimethyl-4,7-diphenyl-1,10-phenanthroline (BCP), bis(2-methyl-8-quinolinolato)(para-phenylphenolato)aluminium(III) (Balq), 4,4'-bis(carbazol-9-yl)biphenyl (CBP), 4,7-diphenyl-1,10-phenanthroline (Bphen), 3-(biphenyl-4-yl)-4-phenyl-5-(4-tert-butylphenyl)-1,2,4-triazole (TAZ), or a combination comprising at least one of the foreoing arylamine-based compounds. Examples of the metal include Ba, Li, Mg, W, Mo, V, Ti, Cs, or a combination comprising at least one of the foregoing metals. Examples of the metal oxide, metal carbide, or metal halide include MoO₃, V₂O₅, WO₃, TiO₂, Cs₂CO₃, BaF, LiF, CsF, or a combination comprising at least one of the foregoing metal oxides, carbides or halides.

The color control layer 40 may be interposed between the cathode 50 and the white organic light-emitting unit 30. Specifically, the color control layer 40 is interposed between the cathode 50 and the electron injection layer 39 of the white organic light-emitting unit 30. Accordingly, the color control layer 40 may be formed to have an electron transporting capability, and specifically, the color control layer 40 may have a greater electron transporting capability than the electron transport layer 38 of the white organic light-emitting unit 30. In general, the electron transport layer of an organic light-emitting device is formed of a material having an electron mobility rate of about 10⁻⁶centimeters squared per Volt second (cm²/Vs). Accordingly, the color control layer 40 may have an electron mobility rate of 10⁻⁶cm²/Vs or more. The color control layer 40 may be formed of the same material, or of a different material, as the electron injection layer 39, which will be described in detail later.

The color control layer 40, formed of the materials described above, may cause a light interference phenomenon. The light interference phenomenon may vary according to the thickness of the color control layer 40, which can be used to control the color balance of light emitted from the white organic light-emitting unit 30. In the case of a bottom-emissive organic light-emitting device that emits light toward the substrate 10, the color balance of light emitted from an organic light-emitting unit can be controlled, since the cathode that is usually a metal electrode acts as a reflective plate.

In another embodiment, a white organic light-emitting device can be manufactured using known methods for fabricating a white organic light-emitting device using an emissive material, without the need for specific apparatuses and/or methods.

When light emitted from the white organic light-emitting unit 30 is to be emitted through the substrate 10, the substrate 10 and the anode 20 may be formed of a transparent material. The anode 20 can be formed on the substrate 10 using an electrode material having a high work function, and through a deposition method or a sputtering method. The substrate 10 can be any known substrate that is used in the manufacture of organic light emitting devices. For example, the substrate 10 is formed of a transparent material having strong mechanical resistance, thermal stability, transparency, being water-proof, a plane surface, and which can be easily treated. Examples of transparent substrates include transparent inorganic substrates, such as quartz and glass; and transparent plastic substrates, such as polyethylene terephthalate ("PET"), polyethylene naphthalate ("PEN"), polycarbonate, polystyrene, polypropylene, polymethylmethacrylate, polyethersulfone ("PES"), or the like; or a combination comprising at least one of the foregoing transparent substrates.

The electrode material used to form the anode 20 is formed of a transparent material having excellent conductivity. Examples of transparent, highly conductive materials include indium tin oxide (ITO), indium-oxide-doped ZnO (IZO), SnO₂, ZnO, or a combination comprising at least one of the foregoing transparent, conductive materials.

In one embodiment, a glass substrate having a thickness of about 0.7 millimeters (mm) on which ITO is patterned to a thickness of about 90 nanometers (nm) is sequentially washed using a neutral detergent, deionized water, and isopropyl alcohol, and then treated with ultraviolet (UV)-ozone.

The white organic light-emitting unit 30 can have a stacked structure comprising the anode 20, a hole transport layer 31, a white emissive layer 32, the electron transport layer 38, and an electron injection layer 39, which are sequentially deposited. However, the order of the stacked structure of the white organic light-emitting unit 30 is not limited thereto. For example, a hole injection layer (not shown) can be formed between the anode 20 and the hole transport layer 31, and a hole blocking layer (not shown) can be formed between the white emissive layer 32 and the electron transport layer 38. In some cases, the hole transport layer 31 may not be formed.

The material for the hole injection layer can be any hole injecting material known in the art. Examples of materials for the hole injection layer include a phthalocyanine compound, such as a copper phthalocyanine; a starburst type amine derivative, such as 4,4',4"-Tri(N-carbazolyl)triphenylamine (TCTA), m-MTDATA, 1 ,3,5-tris[4-(3-methylphenylphenylamino)phenyl]benzene (m-MTDAPB), or MoO₃; or a soluble conductive polymer, such as polyaniline (PANI)/dodecylbenzenesulfonic acid (DBSA) (Pani/DBSA) or poly (3,4-ethylenedioxythiophene)(PEDOT)/poly(4-styrenesulfonate)(PSS) (PEDOT/PSS), polyaniline/camphor sulfonicacid (CSA) (Pani/CSA), polyaniline/poly(4-styrenesulfonate) (PANI/PSS); or a combination comprising at least one of the foregoing hole injection layer materials.

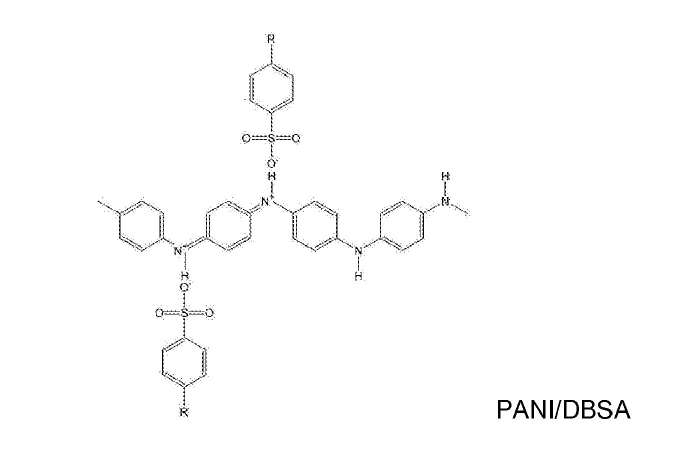

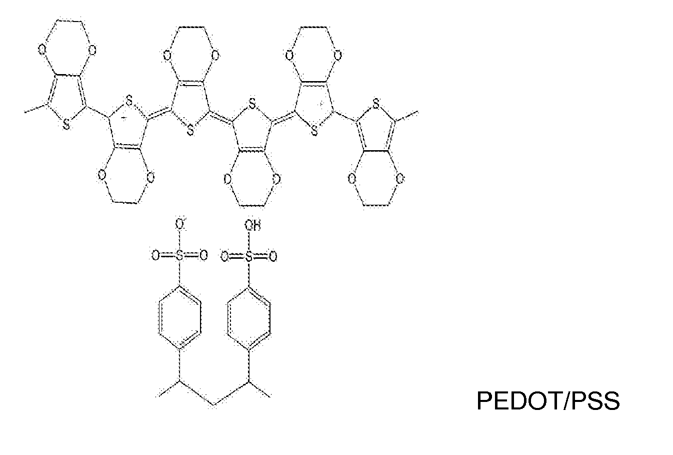

The thickness of the hole injection layer may be in the range from about 100 Angstroms to about 10,000 Angstroms, and specifically, about 100 Angstroms to about 1000 Angstroms. When the thickness of the hole injection layer is less than 100 Angstroms, the hole injecting capability of the hole injection layer may be decreased, on the other hand, when the thickness of the hole injection layer is greater than 10000 Angstroms, the driving voltage of the organic light emitting device may increase. In one embodiment, the hole injection layer (not shown) is a MoO₃ layer having a thickness of 10 nm.

The material for the hole transport layer 31 can be any hole transporting material known in the art. Examples of the material for the hole transport layer 31 include a carbazole derivative, such as N-phenylcarbazole or polyvinylcarbazole; or a conventional amine derivative having an aromatic condensation ring, such as, for example, N,N'-bis (3-methylphenyl)-N,N'-diphenyl-[1,1-biphenyl]-4,4'-diamine (TPD), or N,N'-di (naphthalene-1-yl)-N,N'-diphenyl benzidine (α-NPD); or a combination comprising at least one of the foregoing hole transport layer materials.

The thickness of the hole transport layer 31 may be in the range from about 50 Angstroms to about 1000Angstroms, and specifically, about 100 Angstroms to about 600 Angstroms. When the thickness of the hole transport layer is less than about 50Angstroms, a hole transporting capability of the hole transport layer 31 may be decreased, on the other hand, when the thickness of the hole transport layer is greater than 1000Angstroms, the driving voltage of the organic light emitting device may increase. In one embodiment, the hole transport layer 31 is an α-NPD layer having a thickness of about 30 nm.

The white emissive layer 32 may comprise two emissive layers (not shown) emitting complementary colors with respect to each other, or alternatively, may comprise green, blue, and red emissive layers. To produce various colors using a color filter, one green emissive layer, one blue emissive layer, and one red emissive layer may be included in the white emissive layer 32.

The emissive layers forming the white emissive layer 32, are formed by doping a host material with dopants that can be either fluorescent or phosphorescent light-emitting materials. The blue, red and green emissive layers can each comprise the same host materials. In some cases, the host material for the blue emissive layer may be different from the host material for the green and/or the red emissive layers. The host material can be any host material used in low molecular weight organic light emitting devices. Examples of the host material include 9,10-bis-(β -naphthyl)-anthracene (ADN), 2-tert-butyl-9,10-bis-(β -naphthyl)-anthracene (TBADN), tris(8-quinolinolato)aluminum (Alq₃), or the like, or a combination comprising at least one of the foregoing host materials..

The blue dopant used to form the blue emissive layer is not particularly limited. Examples of the blue dopant include 4,4'-bis(2,2-diphenylvinyl)biphenyl (DPAVBi), a DPAVBi derivative, distyrylarylene (DSA), a distyrylarylene derivative, distyrylbenzene (DSB), a distyrylbenzene derivative, 2,2',7,7'-tetrakis(2,2-diphenylvinyl)-9,9-spirobifluorene (spiro-DPVBi), spiro-6-phenyl (spiro-6P), or a combination comprising at least one of the foregoing blue dopants.

The red dopant used to form the red emissive layer is not particularly limited. Examples of the red dopant include4-(dicyanomethylene)-2-t-butyl-6-(1,1,7,7-tetramethyljulolidyl-9-enyl)-4H-pyra n (DCJTB), 2,3,7,8,12,13,17,18-Octaethyl-21H,23H-porphine platinum (II) (PtOEP), RD 61 (produced by UDC Co), or a combination comprising at least one of the foregoing red dopants.

The green dopant used to form a green emissive layer is not particularly limited. Examples of the green dopant include coumarin 6, Ir(PPy)3(PPy=2-phenylpyridine), or a combination comprising at least one of the foregoing green dopants.

In one embodiment, the blue emissive layer is prepared by doping the host material TBADN with 5 weight percent (wt%) of the blue dopant DPAVBi, the green emissive layer is prepared by doping TBADN with 2 wt% of the green dpoant coumarin, and the red emissive layer is prepared by doping TBADN with 2 wt% the red dopant DCJTB.

The material for the electron transport layer 38 functions to stably transport electrons supplied from the cathode 50, and can be any electron transporting material known in the art. Examples of the material for the electron transport layer 38 include an oxazole-based compound; an isooxazole-based compound; a triazole-based compound; an isothiazole-based compound; an oxadiazole-based compound; a thiadiazole-based compound; a perylene-based compound; an aluminum complex, such as Alq3, BAlq, bis(2-methyl-8-quinolinato)triphenylsilanolate aluminum (III) (Salq), tris(4-methyl-8-quinolinolato)aluminum(III) (Almq3); or a galium complex, such as tris(2-methyl-8-quinolinolato)(pivalato-O) gallium(III) (Gaq'2Opiv), tris(2-methyl-8-quinolinolato)(acetato-O) gallium(III) (Gaq'2Oac), or tris(2-methyl-8-quinolinolato)gallium(III) (2(Gaq'2)).

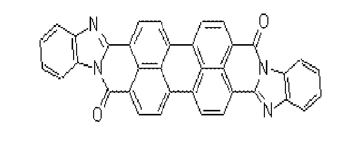

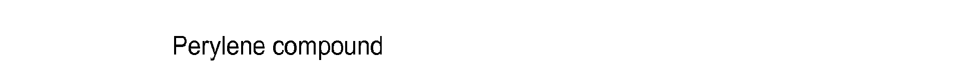

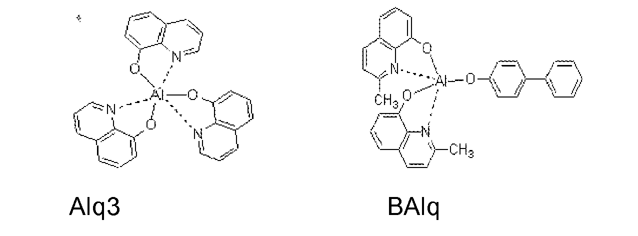

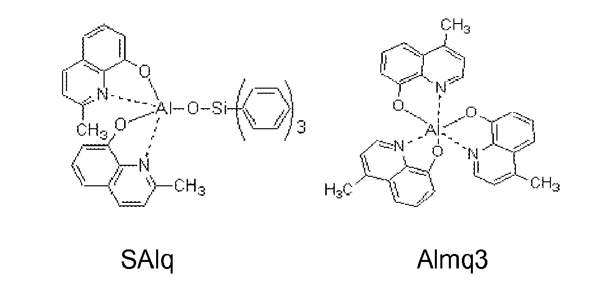

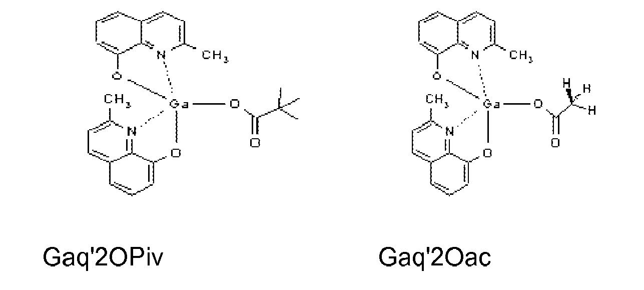

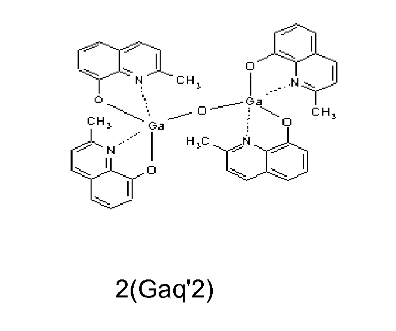

The thickness of the electron transport layer 38 formed of 2(Gaq'2) may be in the range from about 100 Angstroms to about 1000 Angstroms, specifically, about 200 Angstroms to about 500 Angstroms. When the thickness of the electron transport layer 38 is less than about 100 Angstroms, the electron transporting capability of the electron transport layer 38 may be decreased, on the other hand, when the thickness of the electron transporting layer 38 is greater than about 1000 Angstroms, the driving voltage of the organic light emitting device may increase. In one embodiment, the electron transport layer 38 is an Alq₃ layer having a thickness of about 20 nm.

The material for the electron injection layer 39 can be deposited on the electron transporting layer 38. The material for the electron injection layer 39 can be any material that allows electrons to be easily injected from the cathode 50. Examples of material for the electron injection layer 39 include LiF, NaCl, CsF, Li₂O, BaO, a blend of CsCO₃ and BCP, or a combination comprising at least one of the foregoing electron injection layer materials. Deposition conditions for an electron injection layer vary according to the compound used, but in general, are similar to the deposition conditions used for a hole injection layer (not shown). In one embodiment, the electron injection layer 39 is a blended Cs₂CO₃ and BCP layer having a thickness of about 10 nm.

The cathode 50 may be formed of a metal, an alloy, an electro-conductive compound, or a blend thereof, each of which has a low work function. Specifically, examples of the material for the cathode 50 include Li, Mg, Al, Al-Li, Ca, Mg-In, Mg-Ag, or a combination comprising at least one of the foregoing cathode materials. In the case of a front emission light-emitting device, the cathode can be a transmissive electrode formed of ITO or IZO. In one embodiment, the cathode 50 is an aluminum layer having a thickness of about 100 nm.

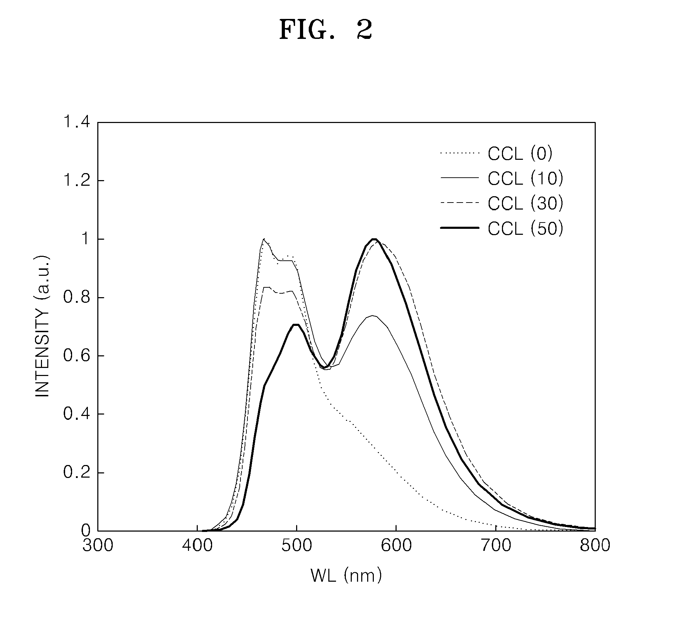

In one embodiment, the color control layer 40 is formed of the same material as the electron injection layer 39. Specifically, the color control layer 40 and the electron injection layer 39 are formed of a blend of Cs₂CO₃ and BCP. FIG. 2 is a graphical view illustrating the emission spectrum for white organic light-emitting devices prepared as illustrated in FIG. 1, and comprising color control layers of differing thicknesses. In FIG. 1 the thickness of the color controlling layer 40 having thickness of 10, 30, or 50 nm are compared and show a color controlling effect with respect to thickness variation. The electro-optical properties of the white organic light-emitting device illustrated in FIG. 1 were also measured. The results are shown in Table 1. Referring to Table 1, CCL is an acronym for color control layer, and denotes the color control layer 40, and the number in parentheses denotes the thickness of the color controlling layer 40 in units of nanometers (nm).

**Table 1**

| Embodiment 1 | Characteristics of Device | | |
|---|---|---|---|
| Thickness of Color control layer (nm) | Turn-on Voltage (V)/ 1000 nit Driving Voltage (V) | 1000 nit DrivingEfficiency(cd/A) | Color Coordinate (CIE @ 1mA) |
| CCL(0) | 2.6/ 6.4 | 7.24 | (0.23, 0.34) |
| CCL(10) | 2.6/6.0 | 6.14 | (0.32, 0.37) |
| CCL(30) | 2.8/ 6.2 | 7.58 | (0.38, 0.40) |
| CCL(50) | 2.8/ 7.8 | 5.33 | (0.40, 0.44) |

Referring to the spectrum illustrated in FIG. 2, and the color coordinates shown in Table 1, it can be seen that as the thickness of the color control layer 40 is changed, the degree of light interference effect changes, the intensity of the emission peak of a long wavelength changes, and the color coordinate changes from (0.23, 0.34) to (0.40, 0.44). When the thickness of the color control layer 40 is about 30 nm, the efficiency of the organic light-emitting device is 8.03 candela per Ampere (cd/A) when the organic light-emitting device is driven at a driving voltage of 1000 nit (SI units for nit = candela per meter squared). Such results show that when the color control layer 40 producing the light interference effect has a suitable thickness, the color balance and efficiency of the white organic light emitting device can be improved.

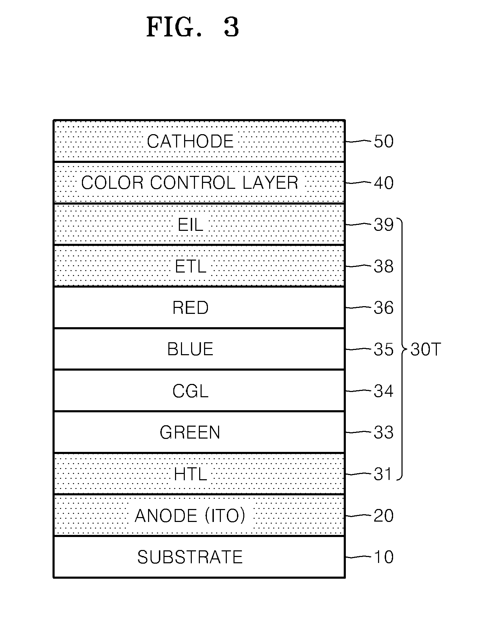

In another embodiment, a white organic light-emitting device comprising a color control layer is provided as illustrated in FIG. 3. The white organic light emitting device comprises almost all of the same components as the white organic light emitting device described with reference to FIG. 1, except that the device of FIG. 3 comprises a charge generation layer (CGL) 34 disposed between two layers selected from a green emissive layer 33, a blue emissive layer 35, and a red emissive layer 36, such that the green emissive layer 33, the blue emissive layer 35, and the red emissive layer 36 form the white emissive layer of the white organic light-emitting unit 30T. The white organic light emitting device is an example of a white organic light emitting device having a tandem structure, in that the CGL 34 is disposed between two layers selected from the green, blue, and red emissive layers 33, 35, and 36 respectively.

The white organic light emitting device demonstrates a high level of color purity while maintaining luminous efficiency at a level higher than or the same as a white organic light emitting device which comprises green, blue and red emissive layers but that does not include a CGL, or as a white organic light emitting device comprising CGLs disposed between every pair of emissive layers.

In the white organic light emitting device, the green, blue, and red emissive layers 33, 35, and 36 can be deposited in a predetermined sequence and the CGL 34 can be disposed between two layers selected from the green, blue, and red emissive layers 33, 35, and 36. That is, the white organic light emitting device comprises only one CGL 34 and thus, has a asymmetric structure in which the CGL 34 is interposed between a single emissive layer, for example, the green emissive layer 33 and two emissive layers, for example, the blue and red emissive layers 35 and 36. When the CGL 34 is interposed between emissive layers connected in series, the current efficiency generated in a single emissive layer can be significantly increased by the two emissive layers connected to the CGL 34. For example, the CGL 34 can be an n-type arylamine-based layer, formed of a blend of Cs₂CO₃ or the like; a BCP layer; or a p-type metal oxide layer, formed of a MoO₃ layer or the like, and these layers may form a complex as a result of an oxidation-reduction reaction occurring when a voltage is applied, thereby generating charges.

The CGL 34 layer may comprises a charge generating compound comprising an aryl amine-based organic compound, a metal, a metal oxide, a metal carbide, a metal boride, or a combination comprising at least one of the foregoing charge generating compounds. Examples of the arylamine-based organic compound include α-NPD, 2-TNATA, TDATA, MTDATA, spiro-TAD, spiro-NPB, or a combination comprising at least one of the foregoing arylamine compounds. Examples of the metal include Cs, Mo, V, Ti, W, Ba, Li, or a combination comprising at least one of the foregoing metals. Examples of the metal oxide, metal carbide, or metal boride include Re₂O₇, MoO₃, V₂O₅, WO₃, TiO₂, Cs₂CO₃, BaF, LiF, CsF, or combinations comprising at least one of the foregoing metal oxides, carbides, and borides.

Table 2 shows the results of measuring the electro-optical properties of the white organic light-emitting device illustrated in FIG. 3. Referring to Table 2, T denotes a tandem structure, CCL denotes the color control layer 40, and the number in parentheses denotes the thickness of the color controlling layer 40

**Table 2**

| Embodiment 2 | Characteristics of Device | | |
|---|---|---|---|
| Thickness of Color control layer (nm) | Turn-on Voltage (V)/ 1000 nit Driving Voltage (V) | 1000 nit DrivingEfficiency (cd/A) | Color Coordinate (CIE @ 1mA) |
| T-CCL(10) | 5.8/ 11.6 | 4.37 | (0.26, 0.34) |
| T-CCL(50) | 5.4/ 11.4 | 7.53 | (0.28, 0.32) |

Referring to the color coordinates shown in Table 2, as the thickness of the color control layer 40 of is changed, a light interference effect occurs, wherein the intensity of the emission peak of a long wavelength changes, and the color coordinate changes from (0.26, 0.34) to (0.28, 0.32). That is, that the increased thickness of the color control layer improved the color balance as evidenced by the fact that the color coordinate shifted closer to (0.31, 0.31), which is a complete white. When the thickness of the color control layer is 10 nm, the current efficiency is 4.37 cd/A at a driving voltage of 1000 nit. When the thickness of the color control layer is 50 nm, the current efficiency is 7.53 cd/A at a driving voltage of 1000 nit. Thus, these results show that when the color control layer producing a light interference effect has a suitable thickness, the color balance and efficiency of the white organic light emitting device can be improved.

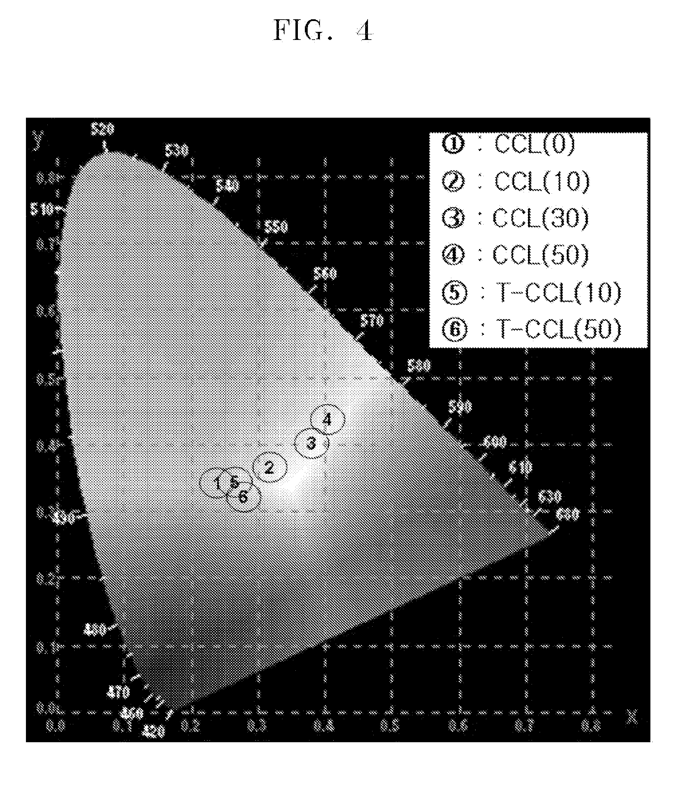

FIG. 4 is a view illustrating a color coordinate system showing the color variation with respect to the thickness of the color control layer for each of the white organic light emitting devices illustrated in FIGS. 2 and 3. Referring to FIG. 4, it can be observed that the color of the white organic light emitting device can be controlled by changing the thickness of the color controlling layer 40 without making any adjustments in the thickness of the hole transport layer 31, or the white emissive layer 30 or 30T, and that the color balance is improved by selecting a proper thickness for the white organic light emitting device 40.

Provided herein is a white organic light emitting device comprising a color controlling layer having an electron transport capability and a light interference effect, interposed between the emissive layer and the cathode, so that a white light having excellent color balance can be provided without a substantial increase in the thickness of the white organic light emitting device.

In addition, the white organic light emitting device can be applied without consideration of the material that is used to form an emissive layer, and in the case of a white organic light-emitting device having a tandem structure, the color balance can be improved by controlling the thickness of a single color control layer.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A white organic light emitting device comprising:
at least one white organic light-emitting unit interposed between an anode and a cathode, and
a color control layer interposed between the cathode and the at least one white organic light emitting unit, the color control layer having an electron transport capability and a light interference effect.

2. The device of claim 1, wherein the color control layer comprises an arylamine-based organic compound, a metal, a metal oxide, a metal carbide, a metal halide, or a combination comprising at least one of the foregoing color control layer materials.

3. The device of claim 2, wherein the arylamine-based organic compound is selected from the group consisting of 2,9-dimethyl-1,10-phenanthroline, bis(2-methyl-8-quinolinolato-N1,O8)-(1,1'-biphenyl-4-olato)aluminum III, 4,4'-bis(carbazol-9-yl)biphenyl, 4,7-diphenyl-1,10-phenanthroline, 3-(Biphenyl-4-yl)-4-phenyl-5-(4-tert-butylphenyl)-1,2,4-triazole , and a combination comprising at least one of the foregoing arylamine-based compounds.

4. The device of claim 2 or 3, wherein the metal is selected from the group consisting of Ba, Li, Mg, W, Mo, V, Ti, Cs, and a combination comprising at least one of the foregoing metals.

5. The device of claim 2, 3 or 4, wherein the metal oxide, metal carbides, or metal halides are selected from the group consisting of MoO₃, V₂O₅, WO₃, TiO₂, Cs₂CO₃, BaF, LiF, CsF, and a combination comprising at least one of the foregoing metal oxides, carbides or borides.

6. The device of any of claims 1-5, wherein the white organic light emitting unit comprises:
a hole transport layer disposed on the anode;
a white emissive layer emitting white light disposed on the hole transport layer;
an electron transporting layer disposed on the white emissive layer; and
an electron injection layer disposed on the electron transport layer,
wherein the color control layer has a higher electron mobility rate than the electron transport layer.

7. The device of claim 6, wherein the color control layer has an electron mobility rate of 10⁻⁶cm²/Vs or more.

8. The device of claim 6 or 7, wherein the white emissive layer comprises one green emissive layer, one blue emissive layer, and one red emissive layer, and a charge generation layer is interposed between the green emissive layer and the blue emissive layer, or between the blue emissive layer and the red emissive layer.

9. The device of claim 8, wherein the charge generation layer comprises an arylamine-based organic compound, a metal, a metal oxide, a metal carbide, a metal halide, or a combination comprising at least one of the foregoing charge layer materials.

10. The device of claim 9, wherein the arylamine-based organic compound is selected from the group consisting of N,N'-dinaphthyl-N,N'-diphenyl bendizine, tris(2-naphthylphenylamino) triphenyl-amine, 4,4',4"-tris(N,N-diphenyl-amino)triphenylamine, 4,4',4"-tris[N,N-(m-tolyl)phenylamino]triphenylamine, 2,2',7,7'-Tetrakis(diphenylamin)-9,9'-spirobifluorene, N,N'-di(1-naphthyl)-N,N'-diphenyl-4,4'-diamonobiphenyl , and a combination comprising at least one of the foregoing arylamine-based compounds.

11. The device of claim 9 or 10, wherein the metal is selected from the group consisting of Cs, Mo, V, Ti, W, Ba, Li, and a combination comprising at least one of the foregoing metals.

12. The device of claim 9, 10 or 11, wherein the metal oxide, metal carbide, or metal halide are selected from the group consisting of Re₂O₇, MoO₃, V₂O₅, WO₃, TiO₂, Cs₂CO₃, BaF, LiF, CsF, and a combination comprising at least one of the foregoing metal oxides, carbides or borides.

13. The device of any of claims 8-12, wherein each of the green, blue and red emissive layers comprises a host material and a fluorescent or phophorescent light-emitting material as a dopant.
